Europäisches Patentamt

(19) European Patent Office (11) Numéro de publication: **0 241 351**
**B1**
Office européen des brevets

(12) **FASCICULE DE BREVET EUROPEEN**

(45) Date de publication du fascicule du brevet: (51) Int. Cl.⁴: **G12B 5/00**, G01R 33/24
14.03.90

(21) Numéro de dépôt: 87400704.0

(22) Date de dépôt: 31.03.87

---

(54) Dispositif d'exploration du volume intérieur d'un cylindre et système d'investigation muni de ce dispositif.

---

(30) Priorité: 01.04.86 FR 8604591

(43) Date de publication de la demande:
14.10.87 Bulletin 87/42

(45) Mention de la délivrance du brevet:
14.03.90 Bulletin 90/11

(84) Etats contractants désignés:
CH DE GB LI NL

(56) Documents cités:
DE-A- 2 704 396
GB-A- 1 452 280
US-A- 3 984 627

PATENT ABSTRACTS OF JAPAN;
vol. 9, no. 203 (P-381)[1926], 21 août 1985; &
JP-A-60 67 862 (MATSUSHITA DENKI SANGYO
K.K.) 18-04-1985
REV. SCI. INSTRUM.,
vol. 48, no. 9, septembre 1977, page 1215, New York, US;
J.F. WENDELKEN et al.: "Simple goniometer for precise
grinding and electropolishing of single crystal
surfaces"

(73) Titulaire: GENERAL ELECTRIC CGR S.A., 100, rue
Camille-Desmoulins, F-92130 Issy les Moulineaux(FR)

(72) Inventeur: Aubert, Guy, THOMSON - CSF SCPI
- 19, avenue de Messine, F-75008 Paris(FR)

(74) Mandataire: Ballot, Paul Denis Jacques et al, Cabinet
Ballot-Schmit 7, rue le Sueur, F-75116 Paris(FR)

---

## Description

La présente invention est due à la collaboration du Service National des Champs Intenses (Directeur M. Guy AUBERT), elle a pour objet un dispositif d'exploration de l'intérieur d'un volume cylindrique, en particulier d'un aimant. Elle peut trouver une application dans le domaine médical où des aimants sont utilisés pour faire de l'imagerie par résonance magnétique nucléaire. Elle peut cependant être utilisée dans d'autres domaines, en particulier pour d'autres aimants cylindriques, ou encore dans d'autres domaines de la technique où on rencontre des volumes cylindriques.

Pour faire de l'imagerie par résonance magnétique nucléaire, il est nécessaire de placer un corps, dont on veut imager des coupes, à l'intérieur d'un champ magnétique continu, intense, et homogène produit par un aimant. Pour améliorer les qualités d'homogénéïté de l'aimant, il est nécessaire de connaître son inhomogénéïté. On mesure l'inhomogénéïté d'un aimant en relevant les valeurs du champ magnétique produit en différents endroits de son volume d'intérêt. A cette fin, on déplace une sonde en ces différents endroits : on explore le volume d'intérêt. On sait, en particulier dans l'imagerie par résonance magnétique, que le champ doit être homogène avec une homogénéïté de l'ordre de quelques parties par million (ppm). Aussi les endroits du volume intérieur où les valeurs de champ sont relevées doivent être repérées géométriquement avec autant de précision que possible. Il arrive aussi quelques fois que les mesures doivent être réitérées, en des mêmes endroits de l'aimant, après exécution de corrections de champ. Il est donc nécessaire, outre la précision, de disposer d'un matériel maniable. Enfin la connaissance du champ produit par un aimant étant d'autant plus grande que l'on a pu y relever les valeurs du champ en un plus grand nombre de points, il est nécessaire que le dispositif d'exploration soit d'utilisation simple.

La présente invention a pour objet de proposer un dispositif d'exploration qui apporte une solution d'ensemble à tous ces problèmes. Pour le maniement et l'installation, le dispositif comporte une armature munie de moyens pour assurer son calage et son réglage à l'intérieur d'un cylindre à explorer. Une fois l'armature mise en place, le dispositif comporte en outre un porte-sonde pouvant se translater parallèlement à l'axe du cylindre, et pouvant pivoter autour de cet axe. Enfin pour la simplicité, le porte-sonde comporte des logements prédécoupés, pour recevoir exactement une sonde de mesure. En choisissant ainsi un logement parmi tous les logements, on explore, par des opérations successives de translation et/ou de rotation, tous les points intérieurs d'un cylindre dont la distance à l'axe du cylindre est la même. Par ailleurs, en changeant la place de la sonde, d'un logement à l'autre, on explore toutes les distances radiales voulues. On peut également disposer simultanément dans les logements plusieurs sondes et explorer les distances radiales correspondantes par commutation manuelle ou éléctronique des sondes.

L'invention concerne un dispositif d'exploration du volume intérieur d'un cylindre, caractérisé en ce qu'il comporte, un porte-sonde, une armature pour servir de support du porte-sonde, des moyens de calage et de réglage en position de l'armature dans le cylindre, des moyens pour faire coulisser le porte-sonde selon l'axe du cylindre, des moyens pour faire pivoter le porte-sonde autour de l'axe du cylindre, le porte-sonde comportant des logements prédéterminés pour recevoir une sonde de mesure.

L'invention sera mieux comprise à la lecture de la description qui suit et à l'examen des figures qui l'accompagnent. Elles ne sont données qu'à titre indicatif et nullement limitatif de l'invention. Sur les différentes figures les cotes et proportions des différents éléments ne sont pas conservées. Cependant les mêmes repères y désignent les mêmes éléments. Les figures montrent :

- figure 1a : une vue en perspective du dispositif selon l'invention, montrant les moyens pour faire coulisser le porte-sonde et le porte-sonde lui-même ;
- figure 1b : une vue en perspective des moyens pour faire pivoter le porte-sonde ;
- figure 2 : une vue en perspective, schématique, des moyens de calage de l'armature.

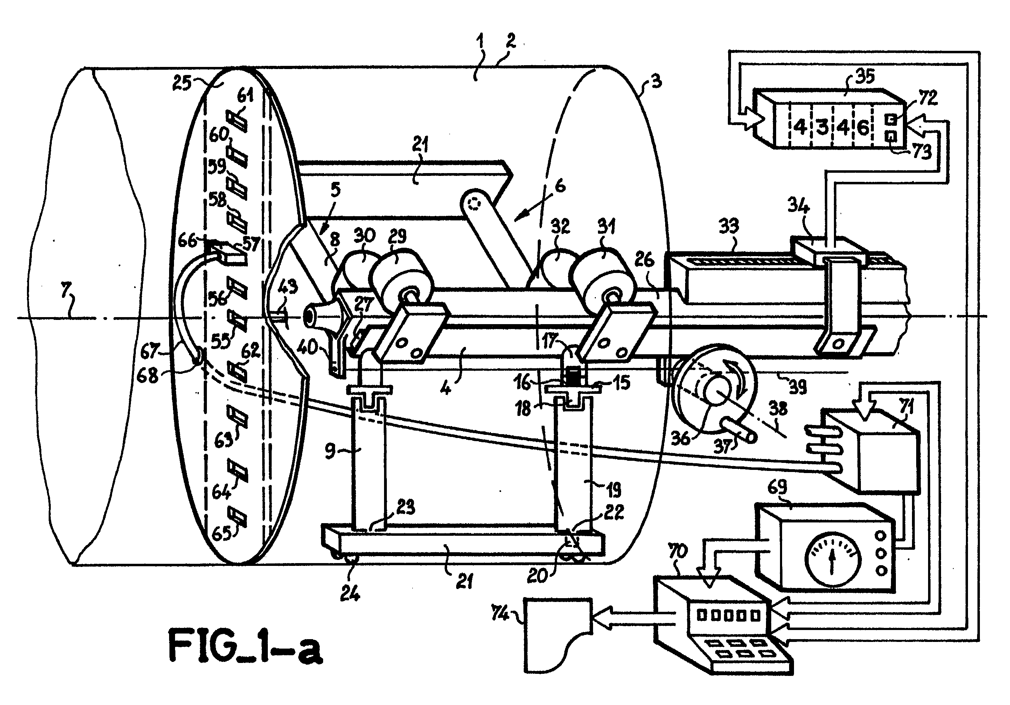

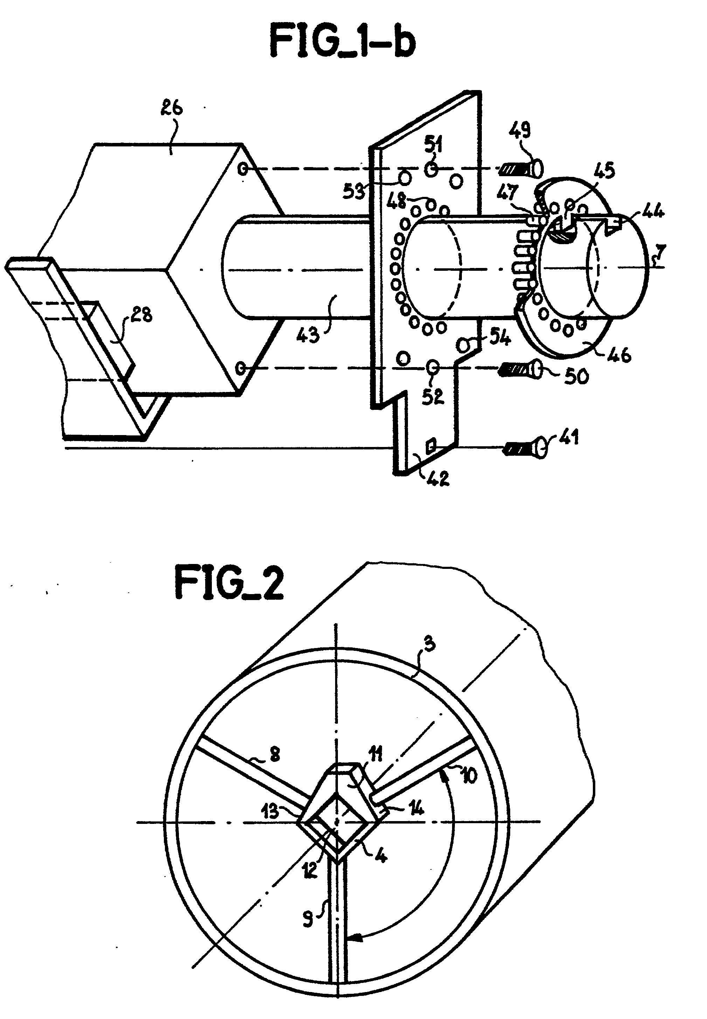

Les figures 1a et 1b représentent le dispositif d'exploration selon l'invention. Le volume intérieur 1 à explorer est rappelé par le dessin d'un cylindre de génératrice 2 et de section droite circulaire 3. Le dispositif d'exploration comporte une armature dont les éléments sont numérotés de 4 à 24. Cette armature comporte essentiellement une glissière 4 soutenue par exemple par deux jeux, respectivement 5 et 6, d'entretoises comportant chacun trois entretoises. Les trois entretoises de chaque jeu sont placées chacune dans un plan différent et sensiblement perpendiculaire à l'axe 7 du cylindre. Dans un exemple, les deux plans sont distants d'environ 30 cm. Dans leur plan respectif, les entretoises sont orientées avec des directions faisant entre elles des angles sensiblement égaux à 120°. Dans la représentation en perspective de la figure 1a, une des entretoises de chaque plan a été omise pour ne pas surcharger le dessin. La figure 2 montre schématiquement la position des entretoises 8 et 9 visibles sur la figure 1a, et de l'entretoise 10 qui n'y est pas représentée. Ces entretoises sont rendues solidaires de la glissière 4 à une de leur extrémité, par tous moyens, notamment par l'intermédiaire d'une pièce pentagonale 11 munie d'un évidement 12 et de deux faces respectivement 13 et 14 pour servir d'embase aux entretoises 8 et 10. L'évidement 12 sert pour la translation du porte-sonde.

Chacune des six entretoises de l'armature comporte une molette de réglage 15 en forme de disque. Une des faces de chaque molette comporte un embout fileté 16 pour s'engager dans un écrou 17 fixé à l'armature (pièce 11), tandis que l'autre face est munie d'un embout cylindrique lisse 18. L'embout 18 est prévu pour s'engager dans un trou ménagé dans la base d'un élément 19 d'entretoise. Chaque élément d'entretoise comporte, à sa tête, également un embout cylindrique lisse 20. Les éléments d'entretoise peuvent être de différentes longueurs, et éventuellement fichés les uns dans les autres, pour constituer une entretoise plus grande. Pour cette raison les diamètres des embouts 20 des entretoises sont compatibles avec les trous effectués dans leur base. Lors de l'installation du dispositif d'exploration à l'intérieur du volume cylindrique, les embouts 20 des têtes des entretoises sont prévus pour être fichés dans des planchers élémentaires tels que 21. Chaque plancher comporte sur une face deux trous, par exemple 22 et 23, prévus pour recevoir des embouts de deux entretoises, par exemple 9 et 19, parallèles entre elles mais situées dans des plans 5 ou 6 différents. Sur une autre face, pour éviter que les planchers ne puissent venir détériorer la face intérieure du cylindre 1, ils sont munis de patins en matière plastique tels que 24. En agissant sur toutes les mollettes de toutes les entretoises, il est possible de caler l'armature par rapport au cylindre 1 en même temps que l'on effectue le réglage en position de cette armature de telle façon qu'ultérieurement un porte-sonde 25 puisse pivoter exactement autour de l'axe 7 du cylindre 1. Les trous des planchers et des bases des entretoises sont légèrement plus larges que les embouts pour faciliter, par le jeu mécanique ainsi conféré, l'accomplissement de ce réglage. En prenant ainsi appui sur la paroi intérieure du cylindre, le dispositif de l'invention s'affranchit de tous les problèmes de calage de ce cylindre sur un support.

Le dispositif d'exploration comporte encore des moyens pour faire coulisser le porte-sonde 25. Ces moyens pour faire coulisser comportent essentiellement un arbre 26 de section polygonale, ici la section est même carrée. L'arbre 26 repose sur la glissière 4 au moyen de patins, tels que 27 ou 28 (figure 1b) de glissement sans frottement. Un certain nombre de ces patins sont ainsi répartis le long de chaque face portante de la glissière 4. Lorsque l'arbre est avancé, quand le porte-à-faux du porte-sonde 25 augmente, des jeux de galets 29,30 et 31,32 exercent une réaction sur des faces supérieures de l'arbre 26. Les axes des galets sont maintenus solidaires de la glissière. Cette réaction empêche l'arbre 26 de basculer. La section de l'arbre 26 est de préférence polygonale pour que les supports et les réactions puissent s'exercer quelque soit la position en abscisse de l'arbre 26. Du côté opposé à celui où est monté le porte-sonde 25, une réglette graduée 33 est fixée sur l'arbre 26. Cette réglette graduée 33 comporte une poutre en verre munie de rayures, régulièrement espacées, qui défilent, quand l'arbre 26 coulisse, devant un codeur optique 34. Le codeur optique 34 compte les rayures et permet de mesurer et d'afficher dans un afficheur 35, l'abscisse de l'extrémité de l'arbre 26.

Pour déplacer l'arbre 26, il est par exemple prévu un tambour 36 solidaire d'une manivelle 37. La manivelle 37 entraîne le tambour à tourner autour d'un axe 38 sensiblement orthogonal à l'axe 7 et fixé à la glissière 4. Un fil 39, ou un câble, est enroulé de quelques tours autour du tambour 36 ; une de ses extrémités est accrochée à une butée 40 solidaire de l'arbre 26, près du porte-sonde 25, tandis que l'autre est fixée par l'intermédiaire d'une vis de réglage de tension 41 à un moyeu d'indexage 42 également rendu solidaire de l'arbre 26 à son autre extrémité. En manoeuvrant la manivelle 37, on fait coulisser l'arbre 26. Ce coulissement est arrêté de part et d'autre lorsque la butée 40 ou le moyeu d'indexage 42 viennent au contact des extrémités de la glissière 4.

Dans un exemple préféré, les moyens pour faire pivoter le porte-sonde 25 autour de l'axe 7 comportent essentiellement un mandrin 43 (figures 1a et 1b) monté libre en rotation à l'intérieur et dans l'axe de l'arbre 26. A l'extrémité arrière (figure 1b) le mandrin comporte une encoche longitudinale 44 pour recevoir un ergot 45 d'un bouton d'indexage 46. Le bouton d'indexage comporte une couronne coulissante autour du mandrin 43 et munie d'un ou d'une pluralité de picots tels que 47. Ce ou ces picots 47 sont prévus pour venir s'engager dans des alvéoles 48 réalisées en regard dans le moyeu d'indexage. Les alvéoles 48 y sont distribuées régulièrement sur une couronne centrée sur l'axe 7 du moyeu. Le moyeu 42 est fixé à l'extrémité de l'arbre 26 par tous moyens, notamment au moyen de deux vis 49 et 50 qui s'engagent dans des trous respectivement 51 et 52 du moyeu 42. Une fois que le moyeu est fixé, on tire le bouton 46 vers l'arrière, l'ergot 45 coulisse dans l'encoche 44.Puis on tourne le mandrin 43 d'un angle désiré, et on enfonce le bouton 46 vers l'avant de manière à ce que le picot 47 vienne s'engager dans un trou 48 choisi à l'avance. Il en résulte qu'à l'autre extrémité le porte-sonde 25 a pivoté autour de l'axe 7, et est maintenant tourné d'un angle prédéterminé. Cet angle correspond à un multiple de l'écart entre deux alvéoles 48 voisines sur le moyeu 42. On peut ainsi explorer le cylindre 1 selon des directions radiales écartées les unes des autres d'un angle égal au pas angulaire des alvéoles 48. Si ce pas angulaire est de finesse insuffisante, ou pour tout autre motif, il est possible de décaler le moyeu 42 d'un certain angle en enlevant les vis 49 et 50 et en les replaçant, après avoir fait tourner le moyeu 42, au travers de trous 53, 54 situés respectivement à côté de chacun des précédents trous 51 et 52. Le pas angulaire entre les trous 51 et 53, et 52 et 54, est de préférence complémentaire du pas angulaire des alvéoles 48. Il est également possible de réaliser un codage de la rotation du mandrin 43 du moyen d'un codeur, par exemple optique, dont de nombreuses réalisations sont disponibles sur le marché.

Le porte-sonde 25 est monté en bout du mandrin 43. Il comporte une série de logements notés 55 à 61, répartis régulièrement radialement. Le logement 55 est situé sur l'axe 7. Si le pas de la distribution des logements 55 à 61 est insuffisamment fin, il est possible de réaliser une autre série de logements, 62 à 66, décalés radialement de ceux de la première série pour augmenter la finesse du jeu d'exploration. L'autre série peut cependant aussi être adaptée à une exploration dont la réparatition radiale serait différente de celle de la première série. Tous les éléments du dispositif d'exploration sont réalisés en matériau amagnétique. En particulier la glissière 4 et l'arbre 26 sont en aluminium ; les jeux d'entretoises, les éléments de plancher, le tambour, la manivelle, le mandrin etc... sont d'une manière préférée en matière plastique amagnétique, en particulier en celle connue sous le nom commercial DELRIN. Les patins de glissement 27 et 28 et les galets 29 à 32 sont recouverts de polytétrafluoroéthylène.

Pour utiliser le dispositif d'exploration selon l'invention, on installe dans un premier temps l'armature à l'intérieur du cylindre 1. Pour régler la position de cette armature, on opère de la façon suivante. On actionne la manivelle 37 pour que la butée 40 vienne s'appuyer sur la glissière 4. Dans cette position, on règle les entretoises du jeu 5 : celles qui sont les plus proches du porte-sonde 25. Le réglage est atteint quand un point extérieur choisi du porte-sonde 25 peut occuper en rotation des positions toutes equidistantes du cylindre 1. Pour faciliter cette opération on peut effectuer le réglage avec des cales appliquées sur l'intérieur du cylindre. Lorsque le jeu 5 est réglé, au moyen de la manivelle 37, on déplace le porte-sonde 25 jusqu'à ce que le moyeu 42 vienne buter à l'autre extrémité de la glissière 4. On entreprend alors, comme pour le jeu 5, le réglage des entretoises du jeu 6. Il n'y a en principe pas lieu de retoucher au réglage des entretoises du jeu 5. En effet, autant le jeu 5 est le seul concerné dans le réglage précédent, autant le réglage du jeu 6 est le seul efficient dans le cas présent. On peut cependant réitérer toute l'opération en ayant soin de replacer le porte-sonde dans les positions adéquates à chaque fois.

D'une manière préférée, pour tenir compte des fléchissements en limite de porte-à-faux, le réglage du jeu 6 est entrepris alors qu'une sonde 66 est engagée dans un des logements du porte-sonde 25. Le poids de cette sonde 66 ainsi que celui de son câble d'alimentation 67 sont ainsi pris en compte pour le fléchissement supplémentaire qu'ils apportent. On procède de même avec plusieurs sondes si on en utilise plusieurs. D'une manière préférée, le câble 67 est ramené vers l'arrière du dispositif en passant à côté si le porte-sonde comporte une pièce radiale ou au travers du porte-sonde 25 par un trou 68 s'il est circulaire. En agissant ainsi on s'assure qu'aucun effort de traction n'est exercé sur la sonde 66 de manière à modifier sa position dans son logement. Lorsque cette installation et ce réglage sont terminés, l'utilisation proprement dite peut commencer.

Dans un premier temps, un opérateur place la sonde 66 dans un logement déterminé. Il engage par ailleurs le bouton d'indexage 46 dans une position donnée du moyeu d'indexage 42. Puis au moyen de la manivelle 37, il déplace le dispositif le long d'une génératrice d'un cylindre intérieur au cylindre 1. A des abscisses prédéterminées, au moyen d'un appareil de mesure 69 (dans l'exemple évoqué un gaussmètre à RMN), il mesure la valeur du champ correspondant. Cette valeur peut être entrée en mémoire dans un ordinateur 70 puis éventuellement écrite sur une liste 74. Lorsque toutes les abscisses prédéterminées de la génératrice ont été explorées, l'opérateur saisit le bouton d'indexage 46, le tire en arrière et le fait pivoter, entraînant avec lui le mandrin 43, d'un angle prédéterminé. Après enfoncement du bouton la mesure des caractéristiques du champ pour les différentes abscisses est alors réentreprise. Ainsi de suite l'expérience continue jusqu'à ce que le bouton d'indexage revienne dans une position identique à celle qu'il occupait au début. A ce moment l'opérateur saisit la sonde 66 et la place dans un autre logement. Puis toute l'opération est recommencée. Pour déplacer la sonde 66, l'opérateur intervient par l'autre extrémité du cylindre 1.

Pour éviter d'avoir à déplacer la sonde 66, on a imaginé d'utiliser simultanément plusieurs sondes introduites chacune dans une alvéole du porte-sonde 25. Les câbles de mesure de ces sondes aboutissent alors à un multiplexeur 71 piloté par l'ordinateur 70. Dans cet exemple préféré de fonctionnement, la procédure d'exploration est la suivante. Alors que le porte-sonde est orienté dans une direction voulue, l'opérateur amène le porte-sonde à une abscisse prédéterminée. Lorsque cette abscisse prédéterminée est atteinte, l'ordinateur 70 envoie une instruction de validation à afficheur 35. Puis l'ordinateur 70 commande en séquence le multiplexeur 71. Le multiplexeur 71 raccorde tour à tour chacune des sondes à l'appareil de mesure 69. Lorsque ces mesures sont enregistrées, l'ordinateur 70 envoie une autorisation de manoeuvre qui éclaire un voyant 72 sur l'afficheur 35. L'opérateur peut alors déplacer une nouvelle fois le porte-sonde pour atteindre une autre abscisse choisie. Ainsi de suite à chaque fois l'ordinateur 70 vérifie que l'abscisse atteinte correspond bien à une abscisse prédéterminée et qui a été au préalable introduite dans sa mémoire. Pendant la mesure, la manoeuvre de la manivelle 37 peut être interdite par l'éclairage d'un voyant 73 également présent sur l'afficheur 35. Par contre si le calage en abscisse n'est pas correct l'ordinateur 70 peut par exemple faire clignoter le voyant 73.

Les mouvements de translation et de rotation du porte-sonde 25 peuvent être motorisés et l'exploration du volume du cylindre peut alors être réalisée automatiquement sous le contrôle de l'ordinateur. La motorisation peut de préférence faire appel à des moyens pneumatiques qui ne produisent pas de champ magnétique.

## Revendications

1. Dispositif (Fig 1a, 1b) d'exploration du volume intérieur d'un cylindre (1), caractérisé en ce qu'il comporte, un porte-sonde (25), une armature (4–24) pour servir de support du porte-sonde, des moyens (5–6) de calage et de réglage en position de l'armature dans le cylindre, des moyens (26–41) pour faire coulisser le porte-sonde selon l'axe du cylindre, des moyens (42–54) pour faire pivoter le porte-sonde autour de l'axe du cylindre, le porte-sonde comportant des logements (55–65) prédéterminés pour recevoir une sonde (66) de mesure.

2. Dispositif selon la revendication 1, caractérisé en ce que l'armature comporte deux jeux (5, 6) de trois entretoises (8, 9, 10), les entretoises de chaque jeu étant maintenues (11), dans un même plan perpendiculaire à l'axe du cylindre, sensiblement à 120° les unes des autres (Fig. 2), un des plans se trouvant sensiblement au droit d'une extrémité de l'armature.

3. Dispositif selon la revendication 2, caractérisé en ce que les entretoises (8–10) sont modulaires (17–20).

4. Dispositif selon l'une quelconque des revendications 1 à 3, caractérisé en ce que les moyens pour faire coulisser comportent un arbre (26) de section polygonale et une glissière (4) fixée à l'armature pour maintenir l'arbre sans frottement et dont le profil est adapté à la section de l'arbre.

5. Dispositif selon la revendication 4, caractérisé en ce que les moyens pour faire coulisser comportent un tambour (36) d'entraînement, un fil (39) entouré sur ce tambour, au moins une extrémité de ce fil, étant reliée à une extrémité de l'arbre.

6. Dispositif selon la revendication 5, caractérisé en ce que les moyens pour faire coulisser comportent une manivelle (37) reliée au tambour d'entraînement.

7. Dispositif selon l'une quelconque des revendications 1 à 6, caractérisé en ce que les moyens pour faire pivoter comportent un mandrin (43) circulaire monté libre en rotation à l'intérieur de l'arbre polygonal.

8. Dispositif selon la revendication 7, caractérisé en ce que les moyens pour faire pivoter comportent un moyeu (42) d'indexage solidaire de l'arbre pour coopérer avec un bouton (46) d'indexage qui maintient le mandrin.

9. Dispositif selon l'une quelconque des revendications 1 à 8, caractérisé en ce que le porte-sonde (25) comporte un flasque (Fig. 1a) fixé à une extrémité du mandrin.

10. Dispositif selon l'une quelconque des revendications 1 à 9 caractérisé en ce qu'il comporte des moyens de mesure (33–34) de la translation du porte-sonde.

11. Dispositif selon l'une quelconque des revendications 1 à 10 caractérisé en ce qu'il comporte des moyens de mesure de la rotation du porte-sonde.

12. Dispositif selon l'une quelconque des revendications 1 à 11 caractérisé en ce qu'il comporte des moteurs de type pneumatique pour assurer la translation et/ou la rotation du porte-sonde.

13. Système d'investigation muni d'un dispositif selon l'une quelconque des revendications 1 à 12, caractérisé en ce qu'il comporte une pluralité de sondes (66) placées chacune dans un logement (55–65) du porte-sonde, et des moyens (70–71) de multiplexage des mesures effectuées par ces sondes.

## Claims

1. A device (figure 1a and 1b) for the investigation of the interior of a cylinder (1) characterized in that it comprises a probe carrier (25), a fitting (4 through 24) for serving as a support for the probe carrier, shifting and regulating means (5 and 6) for the position of the fitting in the cylinder, means (26 through 41) for causing the probe carrier to slide along the axis of the cylinder, and means (42 through 54) to cause the probe carrier to pivot around the axis of the cylinder, the probe carrier comprising predetermined sockets (55 through 65) to receive a measuring probe (66).

2. The device as claimed in claim 1 characterized in that the fitting comprises two sets (5 and 6) of three spacers (8, 9 and 10), the spacers of each set being maintained (11) in a common plane perpendicular to the axis of the cylinder, substantially at 120° between them (figure 2), one of the planes being located substantially adjacent to one end of the fitting.

3. The device as claimed in claim 2 characterized in that the spacers (1 through 10) are modular (17 through 20).

4. The device as claimed in any one of the claims 1 through 3 characterized in that the means to cause sliding motion comprise a shaft (26) with a polygonal section and a slide (4) secured to the fitting in order to support the shaft without any friction and having an outline adapted to the section of the shaft.

5. The device as claimed in claim 4 wherein the means for causing sliding motion comprise a driving (36) and a filament (39) trained around the drum and having at least one end of its ends connected with one end of the shaft.

6. The device as claimed in claim 5 characterized in that the means for causing sliding motion comprise a crank handle (37) connected with the driving drum.

7. The device as claimed in any one of the claims 1 through 6 characterized in that the means for causing pivoting motion comprise a circular mandril (43) mounted for free rotation inside the polygonal shaft.

8. The device as claimed in claim 7 characterized in that the means for causing pivotal motion comprise an indexing hub (42) keyed to the shaft in order to cooperate with an indexing knob (46) which holds the mandril.

9. The device as claimed in any one of the claims 1 through 8 characterized in that the probe carrier (25) comprises a flange (figure 1a) secured to one end of the mandril.

10. The device as claimed in any one of the claims 1 through 9 characterized in that it comprises measuring means (33 and 34) for the translation of the probe carrier.

11. The device as claimed in any one of the claims 1 through 10 characterized in that it comprises means for measuring the rotation of the probe carrier.

12. The device as claimed in any one of the claims 1 through 11 characterized in that it comprises air power motors in order to cause translation and/or rotation of the probe carrier.

13. An investigation system fitted with a device as claimed in any one of the claims 1 through 12 characterized in that it comprises a plurality of probes (66) each located in a socket (55 through 65) of the probe carrier and multiplexing means (70 and 71) for the readings taken by these probes.

## Patentansprüche

1. Vorrichtung (Fig. 1a, 1b) zur Erforschung des Innenvolumens eines Zylinders (1), dadurch gekennzeichnet, daß sie einen Sondenträger (25), eine Armatur (4–24), um als Träger des Sondenträgers zu dienen, Mittel (5–6) zur Festlegung und zur Einstellung der Position der Armatur in dem Zylinder, Mittel (26–41), um den Sondenträger längs der Zylinderachse gleiten zu lassen und Mittel (42–54) umfaßt, um den Sondenträger um die Zylinderachse schwenken zu lassen, wobei der Sondenträger vorbestimmte Aufnahmen (55–65) umfaßt, um eine Meßsonde (66) aufzunehmen.

2. Vorrichtung nach Anspruch 1, dadurch gekennzeichnet, daß die Armatur zwei Sätze (5, 6) von drei Streben (8, 9, 10) umfaßt, wobei die Streben jedes Satzes in einer selben, zur Zylinderachse senkrechten Ebene und im wesentlichen um 120° voneinander (Fig. 2) festgehalten (11) sind, wobei eine dieser Ebenen annähernd zu einem Ende der Armatur rechtwinklig steht.

3. Vorrichtung nach Anspruch 2, dadurch gekennzeichnet, daß die Streben (8–10) modular (17–20) sind.

4. Vorrichtung nach einem der Ansprüche 1 bis 3, dadurch gekennzeichnet, daß die Mittel zum Gleitenlassen eine Welle (26) von polygonalem Querschnitt sowie eine Gleitschiene (4) umfassen, die auf der Armatur befestigt ist, um die Welle reibungslos festzuhalten, und wovon das Profil an den Querschnitt der Welle angepaßt ist.

5. Vorrichtung nach Anspruch 4, dadurch gekennzeichnet, daß die Mittel zum Gleitenlassen eine Antriebstrommel (36) und einen auf dieser Trommel aufgewickelten Draht (39) umfassen, wobei wenigstens ein Ende dieses Drahts mit einem Ende der Welle verbunden ist.

6. Vorrichtung nach Anspruch 5, dadurch gekennzeichnet, daß die Mittel zum Gleitenlassen eine Kurbel (37) umfassen, die mit der Antriebstrommel verbunden ist.

7. Vorrichtung nach einem der Ansprüche 1 bis 6, dadurch gekennzeichnet, daß die Mittel zum Schwenkenlassen einen kreisförmigen Trägerkörper (43) umfassen, der innerhalb der polygonalen Welle frei drehbar gelagert ist.

8. Vorrichtung nach Anspruch 7, dadurch gekennzeichnet, daß die Mittel zum Schwenkenlassen eine Markiernabe (42) umfassen, die mit der Welle fest verbunden ist, um mit einem den Trägerkörper festhaltenden Markierknopf (46) zusammenzuwirken.

9. Vorrichtung nach einem der Ansprüche 1 bis 8, dadurch gekennzeichnet, daß der Sondenträger (25) einen Flansch (Fig. 1a), der an einem Ende des Trägerkörpers befestigt ist, umfaßt.

10. Vorrichtung nach einem der Ansprüche 1 bis 9, dadurch gekennzeichnet, daß sie Mittel (33–34) zur Messung der Translation des Sondenträgers umfaßt.

11. Vorrichtung nach einem der Ansprüche 1 bis 10, dadurch gekennzeichnet, daß sie Mittel zur Messung der Umdrehung des Sondenträgers umfaßt.

12. Vorrichtung nach einem der Ansprüche 1 bis 11, dadurch gekennzeichnet, daß sie Motoren vom pneumatischem Typ umfaßt, um die Translation und/oder die Umdrehung des Sondenträgers zu gewährleisten.

13. Erforschungssystem, das mit einer Vorrichtung nach einem der Ansprüche 1 bis 12 versehen ist, dadurch gekennzeichnet, daß es eine Vielfalt von Sonden (66), wovon jede in einer Aufnahme (55–65) des Sondenträgers angeordnet ist, sowie Mittel (70–71) zur Multiplexierung der durch diese Sonden vorgenommenen Messungen umfaßt.

FIG_1-a

# FIG_1-b

# FIG_2